# EUROPEAN PATENT SPECIFICATION

(11) **EP 2 481 838 B1**
(45) Date of publication and mention of the grant of the patent: **04.03.2015**
(21) Application number: 12151844.3
(22) Date of filing: 19.01.2012
(51) Int. Cl.: C25D 5/12, C25D 5/14, C25D 5/48, C25D 5/56, C23C 14/02, C23C 14/20, C23C 28/02

(54) **Method for applying semi-dry electroplating method on surface of plastic substrate**
Verfahren zur Anwendung eines halb-trockenen Elektroplattierverfahrens auf der Oberfläche eines Kunststoffsubstrats
Procédé d'application de procédé d'électro-placage semi-sec à la surface d'un substrat en plastique

(30) Priority: 28.01.2011 CN 201110030832
(43) Date of publication of application: 01.08.2012
(73) Proprietor: Xiamen Runner Industrial Corporation, Xiamen 361021 (CN)
(72) Inventor: Wu, Zi-bao, 361021 Xiamen (CN); Qiao, Yong-liang, 361021 Xiamen (CN); Yang, Bo, 361021 Xiamen (CN); Lee, Min-Zen, 361021 Xiamen (CN)
(74) Representative: Lang, Christian

(56) References cited:
- WO-A1-2005/095667
- WO-A1-2008/040700
- DE-A1-102010 016 973

## Description

### BACKGROUND OF THE INVENTION

### 1. Field of the invention

The present invention is related to an electroplating method, and more particularly to a method for applying a semi-dry electroplating method on a surface of plastic substrate.

### 2. Description of Related Art

Since applying metalizing electroplating procedure on a surface of a plastic substrate can achieve anti-corrosive, wear-resisting, scratch-resisting effects and a decoration function with beautiful appearance, the application scope of the plastic substrate thus expands. However, such traditional plastic electroplating procedure has two disadvantages including: (1) electroplatable plastic substrates being limited to ABS, PC/ABS and very few kinds of nylon; (2) pretreatment before electroplating procedure (including each procedure of chemical degreasing and cleaning, roughening, naturalization, sensitization, chemical nickel-plating and so forth) resulting in a large amount of discharging waste water, which is not environmental friendly. Therefore, developing a novel green electroplating procedure with reduced discharge is required. Simultaneously, a novel electroplating procedure, which allows all kinds of plastic to conduct metalizing electroplating is more desired. In this way, more economical benefits can be gained while pollution to environment can be reduced.

For expanding application scope of electroplatable plastic, conventional methods are mainly included as follows :
1) Chinese Patent, CN03104647.9, discloses a method for spraying electrically conductive medium on plastic pieces and cooperating electrolytic plating to conduct electroplating of a plastic surface.
2) Chinese Patent, CN02127419.3, used a method for roughening with dichromic acid content and activation of noble metal to metalize different kinds of plastics.
3) Chinese Patent, CN200410018367.2, used a vacuum sputtering method, which form a thin layer of basic metallic coating by sputtering on a surface of non-metallic material to conduct metallization.

The insufficiency of the foregoing methods 1) and 2) is that using dichromic acid and spraying electrically conductive paint result in serious environmental pollution problem and has higher cost of production. Using metallization technology with vacuum evaporation coating on a plastic substrate is more environmentally friendly when compared to the foregoing methods 1) and 2). However, such simple way of vacuum evaporation coating leads to poor adhesion between the plastic substrate and PVD metallic layer. After electroplating, abscission layer, foaming or other phenomena would occur between the plastic substrate and PVD metallic layer or the final electroplating products confront failure in the thermal cycling test or other problems.

WO 2008/040700 A describes a method for applying a metallic coating on a plastic substrate comprising the steps of water-free cleaning, activating, applying a PVD double layer of chromium and nickel, activating once more, electroplating nickel and then chromium or electroplating copper, nickel and chromium in that order.

### SUMMARY OF THE INVENTION

The objective of the present invention is, in view of disadvantages and insufficiency existing in the conventional plastic electroplating procedure, to provide a method for applying a semi-dry electroplating method on a surface of a plastic substrate, which realizes surface metallization of plastic materials, simplifies an electroplating procedure, dramatically reduces the amount of waste water, reduces the pollution to environment and expands electroplatable range of a plastic substrate. This object is solved by the features of the independent claim.

The present invention includes the following steps:
1) conducting water-free cleaning and dust removal to a plastic substrate;
2) conducting a first-time activated treatment to the surface of the plastic substrate;
3) applying a PVD plating metallic base layer, an alloy transition layer and a metallic electrical conductive layer in turn on the activated-treated surface of the plastic substrate;
4) conducting an ultrasonic water washing and a second-time activated treatment on the plastic substrate treated in the step 3);
5) directly electroplating the plastic substrate treated in the step 4) with acid copper or moving it to a nickel plating bath to conduct nickel electroplating;
6) moving the plastic substrate treated in the step 5) into a chromium plating bath to conduct a final chromium electroplating or transferring it to a PVD oven to conduct deposition of chromium layer.

In the step 1), said plastic substrate can use a plastic substrate produced by injection molding or extrusion molding. Said plastic substrate can use engineering-plastics, glass fibers or mineral-powder reinforcing plastics or the like. Said engineering-plastics can be selected from one of ABS, PC, PC/ABS blends, PA6, PETG, PBT, PA66, TPU,TPU/ABS blends or the like. Said glass fiber reinforcing plastics can be selected from one of PA6+glass fiber, PBT+glass fiber, PC+glass fiber, PA66+glass fiber, PP+glass fiber or the like. Said mineral-powder reinforcing plastics can be selected from one of PA6+mineral powder, PP+mineral powder or the like.Said water-free cleaning can use the following methods: First,Electrostatic precipitation of the product surface,then wipe the surface of the product with anhydrous alcohol,And then using ion-source glow cleaning or bias glow cleaning in a PVD oven or corona activated treatment,washing with water first to remove oil then drying if the product surface is severely contaminated with greasy dirt, And then using ion-source glow cleaning or bias glow cleaning in a PVD oven or corona activated treatment.
2) conducting a first-time activated treatment to the surface of the plastic substrate:
   In the step 2), said first-time activated treatment can use following methods: plasma glow modification using ion-source glow or bias glow mode to conduct the activated treatment,or corona activated treatment.

In the step 3), said metallic base layer can be a metallic base layer or an alloy base layer using chromium, titanium, aluminum, nickel, iron, zirconium or the like.Said metallic base layer can use arc ion plating or magnetron sputter plating to produce the PVD base layer. Said alloy transition layer is an alloy layer with at least one metal selected from chromium, titanium, aluminum, nickel, iron, zirconium, copper or the like and can be produced by arc ion plating or magnetron sputter plating. Said metallic electrically conductive layer can be a metallic electrically conductive layer of copper, nickel or other metal. Said metallic electrically conductive layer can use arc ion plating or magnetron sputter plating to produce the PVD base layer.

In the step 4), said ultrasonic water washing comprises transferring the plastic substrate treated in the step 3) into water galvanization line to conduct the ultrasonic water washing. Activating solution used in said second-time activated treatment can use sulfuric acid solution or the like.

In the step 5), if the surface of the plastic substrate is not flat, electroplating starts from plating acid copper. Said nickel electroplating can use at least one of semi-bright nickel, fully-bright nickel, microporous nickel or the like. If the surface of the plastic substrate is flat, electroplating directly starts from electroplating a semi-bright nickel layer, then electroplating a fully-bright nickel layer or a microporous nickel layer or the like.

Since plastics used in conventional electroplating procedure are limited to ABS, PC/ABS and very few PA6, glass fiber reinforced PBT or glass fiber reinforced PC or the like, the electroplating of plastic surfaces suffers from a tremendous limitation. The present invention uses improved PVD surface plating technology to treat the surface of the substrate with the water-free clean, the activated treatment and PVD multilayer technology, to plate the electrically conductive layer on the plastic surface first with physical vapor deposition (PVD), then to transfer the plastic substrate into traditional electroplating procedure to metalize the surface of the plastic material, and to incorporate simplified electroplating to prepare a semi-dry electroplated product with high quality. Pretreatment before electroplating is not required and therefore traditional chemical degreasing, roughening, naturalization, sensitization, chemical nickel-plating and so forth can be ignored. The procedures of electroplating the copper layer, electroplating the nickel layer and electroplating the chromium layer are directly conducted or electroplating chromium can be conducted in a PVD stove. As a result, the semi-dry electroplated product with high quality can be produced. Additionally, the amount of wastewater discharge in the present invention is merely a half of that in the traditional electroplating procedure.

### BRIEF DESCRIPTION OF THE DRAWINGS

The invention, as well as its many advantages, may be further understood by the following detailed description and drawings in which:

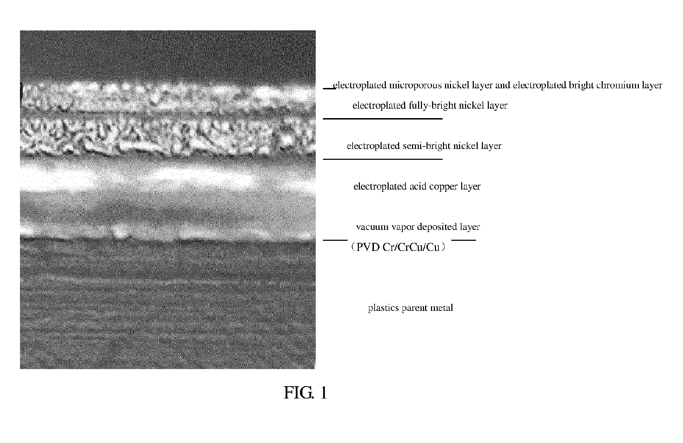

Fig. 1 is a cross-sectional side view of the product prepared by example 1 of the present invention. In Fig. 1, from the bottom to the top, there are a plastic substrate, a vacuum vapor deposited layer (PVD Cr/CrCu/Cu), an electroplated acid copper layer, an electroplated semi-bright nickel layer, an electroplated fully-bright nickel, an electroplated microporous nickel layer, and a electroplated bright chromium layer.

### DETAILED DESCRIPTION OF THE INVENTION

### Example 1: Procedure of semi-dry electroplating method when the surface of a plastic piece is flat

Applying semi-dry electroplating method on a surface of a car-door handle with PC+ABS plastic substrate has following specific steps:
Step 1 (injection molding): PC+ABS engineering plastic resin was dried at 80°C for 4h, and then was injection molded to form a plastic piece of car-door handle. The surface of plastic piece was flat.
Step 2 (cleaning of plastic piece and plasma surface modification): The cleaning (dry cleaning) procedure before plating comprises wiping the surface with anhydrous alcohol and plasma glow cleaning in a PVD stove. Parameters for the plasma glow cleaning comprise: Ar flux being 65sccm, time for glow cleaning being 5min, bias voltage being 70V, bias vacuum ratio being 70%, and ion source current being 0.3A.
   The plastic piece after cleaning was put into a vacuum oven to conduct plasma surface modification. Parameters for the plasma glow surface modification comprise: O₂ 100sccm, ion source current being 0.3A, time for surface modification being 10min, bias voltage being 70V, and bias vacuum ratio being 70%.
Step 3 (PVD metallic base layer and alloy transition layer): For PVD metallic base layer, the target was metallic Cr target and arc ion plating was used for plating. Ar flux was 50sccm, Cr target current was 50A, bias voltage was 60V, bias vacuum ratio was 75%, time for plating was 5min, and vacuum pressure for plating was 0.13Pa. The alloy transition layer was CrCu alloy transition layer using arc Cr target and sputtering Cu target to form a CrCu alloy membrane with arc Cr target current being 50A, copper target current for magnetron sputter plating from 2A gradually raised to 8A, bias voltage being 60V, bias vacuum ratio being 75%, time for plating being 8min, Ar flux being 130sccm, and vacuum pressure for plating being 0.3Pa.
Step 4 (PVD electrically conductive layer): A magnetic sputter plating copper target was used for plating with copper target current being 8A, bias voltage being 70V, bias vacuum ratio being 70%, time for plating being 40min, Ar gas flux being 130sccm, and vacuum pressure for plating being 0.3Pa.
Step 5 (galvanic plating): The product was transferred to hang on plating racks and was started to be plated from water washing and activation before contacting acid copper. Plated layers in turn comprise acid copper, semi-bright nickel, fully-bright nickel, microporous nickel, and bright chromium.

### Example 2: Procedure of semi-dry electroplating method when the surface of a plastic piece is not flat

Applying semi-dry electroplating method on a surface of a faucet knob made of polyamide modified engineering plastics has following specific steps:
Step 1 (injection molding): Polyamide modified engineering plastic powder was dried at 120°C for 4h, and then was injection molded to form a plastic piece of faucet knob. Since the ingredients for modification comprise glass fibers, the surface of plastic piece has little orange peel.
Step 2 (cleaning of plastic piece and plasma surface modification): The cleaning (dry cleaning) procedure before plating comprises wiping the surface with anhydrous alcohol and plasma glow cleaning in a PVD stove. Parameters for the plasma glow cleaning comprise: Ar gas flux being 65sccm, time for glow cleaning being 5min, ion source current being 0.3A , bias voltage being 70V, bias vacuum ratio being 70%, and ion source current being 0.3A. If the surface of the product is contaminated severely, washing with water would be required to remove oil, time for oil-removal and water-washing is 5min and then the surface of the product would be dried under 120□.
   The plastic piece after cleaning was put into a vacuum oven to conduct plasma surface modification. Parameters for the plasma glow surface modification comprise: O₂ gas flux being 100sccm, time for surface modification being 10min, bias voltage being 70V, and bias vacuum ratio being 70%.
Step 3 (PVD metallic base layer and alloy transition layer): For PVD metallic base layer, the target was metallic Cr target and physical sputter plating was used for plating with Ar flux being 130sccm, Cr target current being 8A, bias voltage being 60V, bias vacuum ratio being 75%, time for plating being 5min, and vacuum pressure for plating being 0.29Pa. The alloy transition layer was CrCu alloy transition layer using medium frequency magnetron sputter plating Cr target and magnetron sputter plating Cu target to form a CrCu alloy membrane. Current of the medium frequency magnetron sputter plating Cr target gradually decreased from 8A to 0A, copper target current for magnetron sputter plating gradually raised from 2A gradually raised to 8A, bias voltage was 60V, bias vacuum ratio was 75%, time for plating was 8min, Ar 130sccm, and vacuum pressure for plating being 0.3Pa.
Step 4 (PVD electrically conductive layer): A copper target was used and a magnetic sputter plating was used for plating with copper target current being 8A, bias voltage being 60V, bias vacuum ratio being 75%, time for plating being 40min, Ar 130sccm, and vacuum pressure for plating being 0.3Pa.
Step 5 (galvanic plating): The product was transferred to hang on plating racks and was started to be plated from water washing and activation before contacting acid copper. Plated layers in turn comprise acid copper, semi-bright nickel, fully-bright nickel, microporous nickel, and bright chromium.

### Example 3

Applying semi-dry electroplating method on a plastic substrate surface of a high-density ball head made of polyamide modified engineering plastic has following specific steps

Step 1 (injection molding): Polyamide modified engineering plastic powder was dried at 120°C for 4h, and then was injection molded to form a plastic piece of high-density ball head. The surface of the plastic piece was flat.

Step 2 (cleaning of plastic piece and surface modification): The dried plastic piece was put into a vacuum oven to conduct plasma glow cleaning and plasma surface modification. Parameters for the plasma glow cleaning comprise: Ar gas flux being 65sccm, time for glow cleaning being 5min, ion source current being 0.3A , bias voltage being 70V, bias vacuum ratio being 70%, and ion source current being 0.3A. Parameters for the plasma surface modification comprise: O₂ gas flux being 100sccm, time for gloss surface modification being 10min, bias voltage being 70V, and bias vacuum ratio being 70%.

Step 3 (PVD metallic base layer and alloy transition layer): For PVD metallic base layer, the target was Cr target and arc ion plating was used for plating with Ar flux being 50sccm, Cr target current being 50A, bias voltage being 60V, bias vacuum ratio being 75%, time for plating being 5min, and vacuum pressure for plating being 0.13Pa. The alloy transition layer was CrCu alloy transition layer using arc Cr target and sputtering Cu target to form a CrCu alloy membrane with arc Cr target current being 50A, copper target current for magnetron sputter plating from 2A gradually raised to 8A, bias voltage being 60V, bias vacuum ratio being 75%, time for plating being 8min, Ar flux being 130sccm, and vacuum pressure for plating being 0.3Pa.

Step 4 (PVD electrically conductive layer): A copper target was used as the target and a magnetic sputter plating was used for plating with copper target current being 8A, bias voltage being 60V, bias vacuum ratio being 75%, time for plating being 40min, Ar 130sccm, and vacuum pressure for plating being 0.3Pa.

Step 5 (galvanic plating): The product was transferred to hang on plating racks and was started to be plated from water washing and activation before forming semi-bright nickel. Plated layers in turn comprise semi-bright nickel, fully-bright nickel, microporous nickel, and bright chromium.

The comparison of examples 1∼3 is shown in Table 1.

**Table 1**

| Example | 1 | 2 | 3 |
|---|---|---|---|
| Plastic substrate | ABS+PC | PA6+30%GF+iron powder | PA6+ iron powder |
| plating types | CP | CP | CP |
| Product | Car handle | Cover of faucet | Ball head |
| Appearance of plastic piece | Flat | Little orange peel | Flat |
| Surface cleaning | Anhydrous alcohol wipe | Water washing and removal | Plasma glow cleaning |
| Surface modification | Plasma glow modification | Plasma glow modification | Plasma glow modification |
| Metallic base layer | Are Cr | Sputtering Cr | Arc Cr |
| Alloy transition | CrCu | CrCu | CrCu |
| Electrically-condu ctive layer | cu 1 µm | Cu 1 µm | Cu 1 µm |
| Acid copper | 15∼20µm | 15∼20µm | 0µm |
| Semi-bright nickel | 6µm | 6µm | 6µm |
| Fully-bright nickel | 9µm | 9µm | 9µm |
| Microporous nickel | 1µm | 1µm | 1µm |
| Bright chromium | 0.25µm | 0.25µm | 0.25µm |
| Copper-accelerate d acetic acid-salt spray corrosion test 8h corrosion test | pass | pass | pass |
| Thermal cycling | pass | pass | pass |

## Claims

1. A method for applying semi-dry electroplating method on surface of plastic substrate, **characterized in that** the method comprises following steps including:
1) conducting water-free cleaning and dust removal to a plastic substrate;
2) conducting a first-time activated treatment to the surface of the plastic substrate;
3) applying a PVD plating metallic base layer, an alloy transition layer and a metallic electrical conductive layer in turn on the activated-treated surface of the plastic substrate;
4) conducting ultrasonic water washing and a second-time activated treatment on the plastic substrate treated in the step 3);
5) directly electroplating the plastic substrate treated in the step 4) with acid copper or moving it to a nickel plating bath to conduct nickel electroplating, wherein, if the surface of the plastic substrate is not flat, electroplating starts from plating acid copper and said nickel electroplating uses at least one of semi-bright nickel, fully-bright nickel and microporous nickel, and wherein, if the surface of the plastic substrate is flat, electroplating directly starts from electroplating a semi-bright nickel layer, then electroplating a fully-bright nickel layer or a microporous nickel layer;
6) moving the plastic substrate treated in the step 5) into a chromium plating bath to conduct final chromium electroplating or transferring it to a PVD oven to conduct deposition of chromium layer.

2. The method for applying semi-dry electroplating method on surface of plastic substrate as claimed in claim 1, **characterized in that** in the step 1), said plastic substrate uses a plastic substrate produced by injection molding or extrusion molding; said plastic substrate uses engineering-plastics, glass fibers or mineral-powder reinforcing plastics; said engineering-plastics is selected from one of ABS, PC, PC/ABS, PA6, PETG, PBT, PA66, TPU, TPU/ABS; said glass fiber reinforcing plastics is selected from one of PA6+glass fiber, PBT+glass fiber, PC+glass fiber, PA66+ glass fiber, PP+ glass fiber; said mineral-powder reinforcing plastics is selected from one of PA6+ mineral powder, PP+ mineral powder.

3. The method for applying semi-dry electroplating method on surface of plastic substrate as claimed in claim 1, **characterized in that** in the step 1), said water-free cleaning uses the following methods: (1) electrostatic cleaning, (2) anhydrous alcohol wipe, (3) using ion-source glow cleaning or bias glow cleaning in a PVD oven, (4) corona treatment, (5) washing with water first to remove oil then drying if the product surface is severely contaminated with greasy dirt.

4. The method for applying semi-dry electroplating method on surface of plastic substrate as claimed in claim 1, **characterized in that** in the step 2), said first-time activated treatment uses following methods: (1) plasma glow modification using ion-source glow or bias glow mode to conduct the activated treatment, (2) corona activated treatment.

5. The method for applying semi-dry electroplating method on surface of plastic substrate as claimed in claim 1, **characterized in that** in the step 3), said metallic base layer is metallic base layer or alloy base layer using chromium, titanium, aluminum, nickel, iron, zirconium.

6. The method for applying semi-dry electroplating method on surface of plastic substrate as claimed in claim 1 or 5, **characterized in that** in the step 3), said metallic base layer uses arc ion plating or magnetron sputter plating to produce PVD base layer; said alloy transition layer is an alloy layer with at least two metals selected from chromium, titanium, aluminum, nickel, iron, zirconium, copper and is produced by arc ion plating or magnetron sputter plating.

7. The method for applying semi-dry electroplating method on surface of plastic substrate as claimed in claim 1, **characterized in that in that** in the step 3), said metallic electrically conductive layer is a metallic electrically conductive layer of copper or nickel; said metallic electrically conductive layer uses arc ion plating or magnetron sputter plating.

8. The method for applying semi-dry electroplating method on surface of plastic substrate as claimed in claim 1, **characterized in that** in the step 4), said ultrasonic water washing comprises transferring the plastic substrate treated in the step 3) into water galvanization line to conduct the ultrasonic water washing.

9. The method for applying semi-dry electroplating method on surface of plastic substrate as claimed in claim 1, **characterized in that** in the step 4), activating solution used in said second-time activated treatment uses sulfuric acid solution.

## Patentansprüche

1. Verfahren zur Anwendung eines halbtrockenen Elektroplattierverfahrens an der Oberfläche eines Kunststoffsubstrats, **dadurch gekennzeichnet, dass** das Verfahren die folgenden Schritte beinhaltet:
1) Durchführung eines wasserfreien Reinigungs- und Staubentfernungsschlitts an dem Kunststoffsubstrat,
2) Durchführung einer ersten Aktivierungs-Behandlung an der Oberfläche des Kunststoffsubstrats,
3) PVD-Beschichtung der Oberfläche des Kunststoffsubstrats, welche der Aktivierungsbehandlung unterzogen wurde, der Reihe nach mit einer metallischen Basisschicht, einer Legierungsübergangsschicht und einer metallischen, elektrisch leitfähigen Schicht,
4) Durchführung eines Ultraschallwaschvorgangs mit Wasser und einer zweiten Aktivierungs-Behandlung des Kunststoffsubstrats, welches gemäß Schritt 3) behandelt wurde,
5) Direkte Elektroplattierung des Kunststoffsubstrats, welches gemäß Schritt 4) behandelt wurde, in einem sauren Kupferbad oder durch Eintauchen in ein Vernickelungsbad zur Durchführung einer Elektroplattierung mit Nickel, wobei zunächst die Elektroplattierung in einem sauren Kupferbad erfolgt und die besagte Vernickelung wenigstens mit einer Komponente umfassend Halbglanznickel, Vollglanznickel und mikroporöses Nickel erfolgt, wenn die Oberfläche des Kunststoffsubstrats nicht flach ist, und wobei die Elektroplattierung direkt durch eine Elektroplattierung mit einer Halbglanznickelschicht und einer anschließenden Elektroplattierung mit einer Vollglanznickelschicht oder einer mikroporösen Nickelschicht erfolgt, wenn die Oberfläche des Kunststoffsubstrats flach ist,
6) Überführung des Kunststoffsubstrats, welches gemäß dem Schritt 5) behandelt wurde, in ein Verchromungsbad, um eine abschließende Elektroplattierung mit Chrom durchzuführen oder dessen Überführung in einen PVD - Ofen, um eine Abscheidung einer Chromschicht durchzuführen.

2. Verfahren zur Anwendung eines halbtrockenen Elektroplattierverfahrens an der Oberfläche eines Kunststoffsubstrats nach Anspruch 1, **dadurch gekennzeichnet, dass** als besagtes Kunststoffsubstrat in Schritt 1) ein Kunststoffsubstrat verwendet wird, das durch Spritzguss oder Strangpressen hergestellt ist, wobei das besagte Kunststoffsubstrat einen technischen Kunststoff, glasfaser- oder mineralpulver-verstärkten Kunststoff beinhaltet, wobei ein besagter technischer Kunststoff aus einer Gruppe ausgewählt ist, welche ABS, PC, PC/ABS, PA6, PETG, PBT, PA66, TPU und TPU/ABS umfasst, wobei ein besagter glasfaser-verstärkter Kunststoff aus einer Gruppe ausgewählt ist, welche PA6+Glasfasern, PBT+Glasfasern, PC+Glasfasern, PA66+ Glasfasern und PP+ Glasfasern umfasst, wobei ein besagter mineralpulver-verstärkter Kunststoff aus einer Gruppe ausgewählt ist, welche PA6+Mineralpulver oder PP+Mineralpulver umfasst.

3. Verfahren zur Anwendung eines halbtrockenen Elektroplattierverfahrens an der Oberfläche eines Kunststoffsubstrats nach Anspruch 1, **dadurch gekennzeichnet, dass** die besagte wasserfreie Reinigung in Schritt 1) auf einem der nachfolgenden Verfahren beruht: (1) elektrostatische Reinigung, (2) Abreiben mit wasserfreiem Alkohol, (3) Anwendung einer Ionenquellen - Glimmentladung oder einer Vorspannungsglimmentladung zur Reinigung in einem PVD - Ofen, (4) Korona - Behandlung, wobei (5) die Produktoberfläche zunächst mit Wasser gewaschen und anschließend getrocknet werden kann, um Öl zu entfernen, wenn die Produktobeifläche stark mit fettigen Substanzen verschmutzt ist.

4. Verfahren zur Anwendung eines halbtrockenen Elektroplattierverfahrens an der Oberfläche eines Kunststoffsubstrats nach Anspruch 1, **dadurch gekennzeichnet, dass** die besagte erste Aktivierungs-Behandlung in Schritt 2) auf einem der nachfolgenden Verfahren beruht: (1) Plasmaglimmentladungsbehandlung, wobei eine Ionenquellen-Glimmentladung oder ein Vorspannungsglimmzustand verwendet wird, um eine Aktivierungs-Behandlung durchzuführen, (2) Korona-Aktivierungs-Behandlung.

5. Verfahren zur Anwendung eines halbtrockenen Elektroplattierverfahrens an der Oberfläche eines Kunststoffsubstrats nach Anspruch 1, **dadurch gekennzeichnet, dass** die besagte metallische Basisschicht in Schritt 3) eine metallische Basisschicht oder Legierungsbasisschicht ist, welche Chrom, Titan, Aluminium, Nickel, Eisen, Zirkon umfasst.

6. Verfahren zur Anwendung eines halbtrockenen Elektroplattierverfahrens an der Oberfläche eines Kunststoffsubstrats nach Anspruch 1 oder 5, **dadurch gekennzeichnet, dass** die besagte metallische Basisschicht in Schritt 3) mittels einer Lichtbogen-Ionenplattierung oder Magnetron-Sputterplattierung hergestellt ist, wobei eine PVD - Basisschicht erzeugt wird, wobei die besagte Legierungsübergangsschicht eine Legierungsschicht aus wenigstens zwei Metallen umfasst, welche aus einer Gruppe ausgewählt sind, die Chrom, Titan, Aluminium, Nickel, Eisen, Zirkon und Kupfer beinhaltet und mittels Lichtbogen-Ionenplattierung oder Magnetron-Sputterplattierung hergestellt ist.

7. Verfahren zur Anwendung eines halbtrockenen Elektroplattierverfahrens an der Oberfläche eines Kunststoffsubstrats nach Anspruch 1, **dadurch gekennzeichnet, dass** die besagte metallische, elektrisch leitfähige Schicht in Schritt 3) eine metallische, elektrisch leitfähige Schicht aus Kupfer oder Nickel ist, wobei die besagte metallische, elektrisch leitfähige Schicht mittels einer Lichtbogen-Ionenplattierung oder Magnetron-Sputterplattierung hergestellt ist.

8. Verfahren zur Anwendung eines halbtrockenen Elektroplattierverfahrens an der Oberfläche eines Kunststoffsubstrats nach Anspruch 1, **dadurch gekennzeichnet, dass** der besagte Ultraschallwaschvorgang mit Wasser in Schritt 4) beinhaltet, dass das Kunststoffsubstrat, welches gemäß Schritt 3) behandelt wurde, in eine Wasser-Galvanisierungsanlage überführt wird, um den Ultraschallwaschvorgang mit Wasser durchzuführen.

9. Verfahren zur Anwendung eines halbtrockenen Elektroplattierverfahrens an der Oberfläche eines Kunststoffsubstrats nach Anspruch 1, **dadurch gekennzeichnet, dass** die Aktivierungslösung, welche in Schritt 4) in der besagten zweiten Aktivierungs-Behandlung eingesetzt wird, eine Schwefelsäurelösung ist.

## Revendications

1. Procédé pour appliquer un procédé d'électrodéposition semi-sèche sur la surface d'un substrat en plastique, **caractérisé en ce que** le procédé comprend les étapes suivantes comprenant :
1) le fait d'effectuer un nettoyage sans eau et d'enlever la poussière d'un substrat en plastique ;
2) le fait d'effectuer un traitement activé pour la première fois sur la surface d'un substrat en plastique ;
3) l'application d'une couche de base métallique de placage PVD, d'une couche de transition en alliage et d'une couche électroconductrice métallique en alternance sur la surface traitée activée du substrat en plastique ;
4) le fait d'effectuer un bain ultrasonique et un traitement activé pour la seconde fois sur le substrat en plastique traité dans l'étape 3) ;
5) l'électrodéposition directement du substrat en plastique traité dans l'étape 4) avec du cuivre acide ou le déplacement de celui-ci dans un bain de nickelage pour effectuer une électrodéposition de nickel, cependant que, si la surface du substrat en plastique n'est pas plate, l'électrodéposition commence à partir du cuivre acide de placage et ladite électrodéposition de nickel utilise au moins l'un des métaux nickel semi-brillant, nickel brillant et nickel microporeux et cependant que, si la surface du substrat en plastique est plate, l'électrodéposition commence directement à partir de l'électrodéposition d'une couche de nickel semi-brillant, ensuite de l'électrodéposition d'une couche de nickel brillant ou d'une couche de nickel microporeux ;
6) le déplacement du substrat en plastique traité dans l'étape 5) dans un bain de placage de chrome pour effectuer l'électrodéposition finale du chrome ou le transfert de celui-ci dans un four de PVD pour effectuer le dépôt de la couche de chrome.

2. Procédé pour appliquer un procédé d'électrodéposition semi-sèche sur la surface d'un substrat en plastique selon la revendication 1, **caractérisé en ce que** dans l'étape 1) ledit substrat en plastique utilise un substrat en plastique produit par moulage par injection ou par moulage par extrusion, ledit substrat en plastique utilise du plastique technique, des fibres de verre ou des plastiques renforcés par poudre minérale, ledit plastique technique étant sélectionné parmi l'un des plastiques suivants ABS, PC, PC/ABS, PA6, PETG, PBT, PA66, TPU, TPU/ABS, ledit plastique renforcé en fibres de verre étant sélectionné parmi l'un des plastiques suivants PA6 + fibres de verre, PBT + fibres de verre, PC + fibres de verre, PA66 + fibres de verre, PP + fibres de verre, ledit plastique renforcé par poudre minérale étant sélectionné parmi l'un des plastiques suivants PA6 + poudre minérale, PP + poudre minérale.

3. Procédé pour appliquer un procédé d'électrodéposition semi-sèche sur la surface d'un substrat en plastique selon la revendication 1, **caractérisé en ce que** dans l'étape 1) ledit nettoyage sans eau utilise les procédés suivants : (1) nettoyage électrostatique, (2) essuyage à l'alcool anhydre, (3) utilisation d'un nettoyage par effluvage ionique ou nettoyage par décharge luminescente sur échantillons dans un four PVD, (4) traitement Corona, (5) lavage avec de l'eau premièrement pour enlever l'huile, ensuite séchage si la surface du produit est fortement contaminée par de la poussière grasse.

4. Procédé pour appliquer un procédé d'électrodéposition semi-sèche sur la surface d'un substrat en plastique selon la revendication 1, **caractérisé en ce que** dans l'étape 2), ledit traitement activé pour la première fois utilise les procédés suivants : (1) modification par décharge luminescente de plasma utilisant ou mode de décharge luminescente sur échantillons pour effectuer le traitement activé, (2) traitement Corona activé.

5. Procédé pour appliquer un procédé d'électrodéposition semi-sèche sur la surface d'un substrat en plastique selon la revendication 1, **caractérisé en ce que** dans l'étape 3) ladite couche de base métallique est une couche de base métallique ou une couche de base en alliage qui utilise le chrome, le titane, l'aluminium, le nickel, le fer, le zirconium.

6. Procédé pour appliquer un procédé d'électrodéposition semi-sèche sur la surface d'un substrat en plastique selon la revendication 1 ou 5, **caractérisé en ce que** dans l'étape 3) ladite couche de base métallique utilise le placage ionique ou pulvérisation de magnétron pour produire la couche de base PVD, ladite couche de transition en alliage étant une couche d'alliage avec au moins deux métaux sélectionnés parmi le chrome, le titane, l'aluminium, le nickel, le fer, le zirconium, le cuivre et étant produire par placage ionique ou pulvérisation de magnétron.

7. Procédé pour appliquer un procédé d'électrodéposition semi-sèche sur la surface d'un substrat en plastique selon la revendication 1, **caractérisé en ce que** dans l'étape 3) ladite couche électroconductrice métallique est une couche électroconductrice métallique de cuivre ou de nickel, ladite couche électroconductrice utilisant le placage ionique ou la pulvérisation de magnétron.

8. Procédé pour appliquer un procédé d'électrodéposition semi-sèche sur la surface d'un substrat en plastique selon la revendication 1, **caractérisé en ce que** dans l'étape 4) ledit lavage à l'eau à bain ultrasonique comprend le transfert du substrat en plastique traité dans l'étape 3) dans une ligne de galvanisation à l'eau pour effectuer le lavage à l'eau à ultrasons.

9. Procédé pour appliquer un procédé d'électrodéposition semi-sèche sur la surface d'un substrat en plastique selon la revendication 1, **caractérisé en ce que** dans l'étape 4) la solution d'activation utilisée dans ledit traitement activé pour la seconde fois utilise une solution d'acide sulfurique.
